(19) 

**Europäisches Patentamt**

**European Patent Office**

**Office européen des brevets**

(11) **EP 4 718 714 A1**

(12) **EUROPEAN PATENT APPLICATION**

(43) Date of publication:
01.04.2026 Bulletin 2026/14

(21) Application number: 25204428.4

(22) Date of filing: 24.09.2025

(51) International Patent Classification (IPC):
$H03F\ 1/02^{(2006.01)}$ $\qquad$ $H03F\ 1/56^{(2006.01)}$
$H03F\ 3/195^{(2006.01)}$

(52) Cooperative Patent Classification (CPC):
H03F 1/0288; H03F 1/565; H03F 3/195;
H03F 2200/387; H03F 2200/391; H03F 2200/451

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 27.09.2024 CN 202411371555

(71) Applicant: NXP USA, Inc.
Austin, TX 78735 (US)

(72) Inventor: HUA, Qi
5656AG Eindhoven (NL)

(74) Representative: Hardingham, Christopher Mark
NXP Semiconductors
Intellectual Property Group
The Cattle Barn
Upper Ashfield Farm, Hoe Lane
Romsey, Hampshire SO51 9NJ (GB)

(54) **AN AMPLIFIER AND A CIRCUIT ARRANGEMENT THEREOF**

(57) A circuit arrangement comprises an output combiner circuit including a first output network having a first amplifier output node for connection to a first output of the main amplifier, a second output network having a second amplifier output node for connection to a second output of the peaking amplifier, and a final summing node. The first output network comprises a first inductive element connected between the first amplifier output node and a first intermediate node, a second inductive element connected between the first intermediate node and the final summing node, and a third inductive element connected between the first intermediate node and ground. The second output network comprises a fourth inductive element connected between the second amplifier output node and a second intermediate node, a fifth inductive element connected between the second intermediate node and ground, and a capacitive element connected between the second intermediate node and the final summing node.

FIG.2

**Description**

BACKGROUND

The present application is generally directed to amplifiers, and more particularly a Doherty amplifier and a circuit arrangement for the Doherty amplifier.

Massive MIMO technology is a key component and used in 5G and 6G communication, which requires multiple channels of high efficiency PA (power amplifier) in one base station. Compared with 5G systems which may comprise 32 channels or 64 channels, the channel number in 6G systems will become larger, and 128 channels may be the mainstream in 7GHz deployment. Therefore, it brings many challenges on cost and PCB size.

Therefore, there is a need for Doherty amplifiers which may have the advantages of size reduction, cost savings and high efficiency, both at deep back-off and normal output power levels.

SUMMARY

This summary is provided to introduce a selection of concepts in a simplified form that are further described below in the Detailed Description. This summary is not intended to be relied on to identify important features or essential features of the claimed subject matter, nor is it intended to be used to limit the scope of the claimed subject matter.

According to one aspect of the application, it provides a circuit arrangement for a Doherty amplifier having a main amplifier and a peaking amplifier. The circuit arrangement comprises an output combiner circuit including a first output network having a first amplifier output node for connection to a first output of the main amplifier, a second output network having a second amplifier output node for connection to a second output of the peaking amplifier, and a final summing node. The first output network comprises a first inductive element connected between the first amplifier output node and a first intermediate node, a second inductive element connected between the first intermediate node and the final summing node, and a third inductive element connected between the first intermediate node and ground. The second output network comprises a fourth inductive element connected between the second amplifier output node and a second intermediate node, a fifth inductive element connected between the second intermediate node and ground, and a capacitive element connected between the second intermediate node and the final summing node. In this way, compared to traditional circuit arrangements for a conventional Doherty amplifier which has fixed load impedance or only can modify the real part of the load impedance, the proposed circuit arrangement can provide an output Doherty combiner for an advanced complex combining load (ACCL) Doherty amplifier which increases design freedom because the real part and the image part of the complex load impedance can be adjusted separately to meet different requirements.

In one or more embodiments, the first output network comprises a second capacitor (262) and the second output network comprises a third capacitor (264), and wherein a first terminal of the second capacitor is connected to the third inductive element and a first power supply; a second terminal of the second capacitor is connected to ground, and wherein a first terminal of the third capacitor is connected to the fifth inductive element and a second power supply, a second terminal of the third capacitor is connected to ground.

In one or more embodiments, the voltage provided by the first power supply is the same as the voltage provided by the second power supply.

In one or more embodiments, the first capacitor is integrated within a first integrated passive device (IPD), the second capacitor is integrated within a second IPD, and the third capacitor is integrated within a third IPD.

In one or more embodiments, each one of the first inductive element, the second inductive element, the third inductive element, the fourth inductive element and the fifth inductive element comprises a respective set of bond wires.

In one or more embodiments, the circuit arrangement comprises another inductive element connected between the final summing node and a Doherty amplifier output.

In one or more embodiments, the circuit arrangement further comprises a main amplifier including a first amplifier input connected to the first input, and a first amplifier output connected to the first output circuit; a peaking amplifier including a second amplifier input connected to the second input, and a second amplifier output connected to the second output circuit.

In one or more embodiments, the main amplifier comprises a first input impedance matching network and a first power transistor, wherein the first input impedance matching network is configured to match the impedance between the first input terminal and the first power transistor; and the peaking amplifier comprises a second input impedance matching network and a second power transistor, wherein the second input impedance matching network is configured to match the impedance between the second input terminal and second power transistor.

In one or more embodiments, the first power transistor is a field effect transistor with a gate terminal connected to the first input impedance matching network, a drain terminal connected to the first inductive element, and a source terminal connected to ground, and the second power transistor is a field effect transistor with a gate terminal connected to the second input impedance matching network, a drain terminal connected to the fourth inductive element, and a source terminal connected to ground.

In one or more embodiments, the first inductive element and the second inductive element have the same inductance value.

In one or more embodiments, a ratio $\alpha$ of the peaking amplifier die size to the main amplifier die size is in the range of 1 to 3.

According to a second aspect of the application, it provides a packaged amplifier device. The device comprises a first input terminal; a second input terminal; an output terminal; a main amplifier including a first amplifier input connected to the first input terminal, and a first amplifier output connected to a first combining network input of the output combiner circuit; a peaking amplifier including a second amplifier input connected to the second input terminal, and a second amplifier output connected to a second combining network input of the output combiner circuit; and an output combiner circuit comprising a first inductive element connected between the first amplifier output and a first integrated passive device (IPD), a second inductive element connected between the first IPD and a second IPD, and a third inductive element connected between the first IPD and ground, wherein the first inductive element, the second inductive element and the third inductive element are connected to each other through the first IPD; a fourth inductive element connected between the second amplifier output and a first capacitor, a fifth inductive element connected between the first capacitor and ground, and wherein the first capacitor is integrated within the second IPD which is connected to the output terminal.

In one or more embodiments, each one of the first inductive element, the second inductive element, the third inductive element, the fourth inductive element, and the fifth inductive element comprises a set of bond wires respectively.

In one or more embodiments, the packaged amplifier device further comprises a second capacitor and a third capacitor, and wherein the second capacitor is integrated in a second third IPD and the third capacitor is integrated in a fourth IPD.

In one or more embodiments, the first inductive element is connected to a first power supply and the fourth inductive element is connected to a second power supply.

In one or more embodiments, the voltage provided by the first power supply is the same as the voltage provided by the second power supply.

In one or more embodiments, the main amplifier comprises a first input impedance matching network and a first power transistor, wherein the first input impedance matching network is configured to match the impedance between the first input and the first power transistor; the peaking amplifier comprises a second input impedance matching network and a second power transistor, wherein the second input impedance matching network is configured to match the impedance between the second input and the second power transistor.

In one or more embodiments, the first power transistor is a field effect transistor with a gate terminal connected to the first input impedance matching network, a drain terminal connected to the first inductive element, and a source terminal connected to ground, the second power transistor is a field effect transistor with a gate terminal connected to the second input impedance matching network, a drain terminal connected to the fourth inductive element, and a source terminal connected to ground.

In one or more embodiments, the ratio $\alpha$ of peaking amplifier die size to main amplifier die size is in the range of 1 to 3.

In one or more embodiments, the load modulation ratio $\beta$ is greater than or equal to $\alpha+1$.

BRIEF DESCRIPTION OF THE DRAWINGS

So that the manner in which the above recited features of the present application can be understood in detail, a more particular description of the application, briefly summarized above, may be had by reference to embodiments, some of which are illustrated in the appended drawings. It is to be noted, however, that the appended drawings illustrate only typical embodiments of this application and are therefore not to be considered limiting of its scope, for the application may admit to other equally effective embodiments. The drawings are for facilitating an understanding of the application and thus are not necessarily drawn to scale. Advantages of the subject matter claimed will become apparent to those skilled in the art upon reading this description in conjunction with the accompanying drawings, in which like reference numerals have been used to designate like elements, and in which:

FIG. 1 illustrates a simplified schematic diagram of a conventional Doherty amplifier;

FIG. 2 illustrates a circuit arrangement for a Doherty amplifier in accordance with an embodiment;

FIG. 3 illustrates a Doherty amplifier model with complex combing load in accordance with an embodiment;

FIG. 4 illustrates a device for a Doherty amplifier in accordance with an embodiment;

FIG. 5 illustrates a physical layout of a packaged amplifier device in accordance with an embodiment;

FIG. 6 illustrates Smith chart illustrating the impedance trajectories of Zc and Zp;

FIG. 7A and FIG. 7B are Smith charts illustrating the impedance of Zc, Zp and ZL at the full power condition and the back off power condition;

FIG. 8A and FIG. 8B illustrate the drain efficiency curves versus output back-off;

FIG. 9 illustrates a flowchart of a method of fabricating a RF amplifier in accordance with an example combination.

DETAILED DESCRIPTION

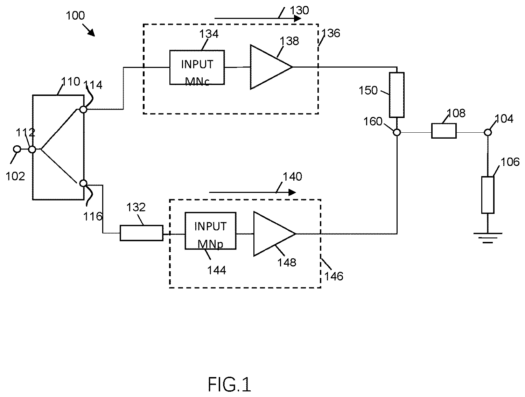

FIG. 1 is a simplified schematic diagram of a conventional Doherty amplifier 100. Amplifier 100 includes a single input terminal 102, an output terminal 104, a power splitter 110, a first amplifier path 130, a second amplifier path 140, and a combining terminal 160. A load 106 (e.g., an antenna) may be connected to the combining terminal 160 through an impedance transformer 108, in an embodiment. The impedance transformer 108 may impart a 90 degrees phase delay to the output RF signal before it is supplied to the load 106.

Power splitter 110 is configured to divide the input power of an input signal 102 received at power splitter input 112 into main and peaking portions of the input signal. The main input signal is provided to the first amplifier path 130 at power splitter output 114, and the peaking input signal is provided to the second amplifier path 140 at power splitter output 116. During operation in a full-power mode when both the main and peaking amplifiers 136, 146 are supplying current to the load 106, the power splitter 110 divides the input signal power between the amplifier paths 130, 140. For example, the power splitter 110 may divide the power equally, such that roughly one half of the input signal power is provided to each path 130, 140 (e.g., for a symmetric Doherty amplifier configuration). Alternatively, the power splitter 110 may divide the power unequally (e.g., for an asymmetric Doherty amplifier configuration).

Essentially, the power splitter 110 divides an input RF signal supplied at the input terminal 102, and the divided signals are separately amplified along the main and second amplifier paths 130, 140. The amplified signals are then combined in phase at the combining terminal 160. It is important that phase coherency between the main and second amplifier paths 130, 140 is main across a frequency band of interest to ensure that the amplified main and peaking signals arrive in phase at the combining terminal 160, and thus to ensure proper Doherty amplifier operation.

Each of the first amplifier 136 and the second amplifier 146 includes one or more single stage or multiple-stage power transistor integrated circuits (ICs) 138, 148 for amplifying an RF signal conducted through the amplifier 136, 146. These power transistor ICs may be implemented, for example, using silicon-based field effect transistors (FETs) (e.g., laterally diffused metal oxide semiconductor FETs, or LDMOS FETs), gallium nitride (GaN)-based FETs (e.g., high electron mobility transistors), or other types of power transistors. Although the main and peaking power transistor ICs may be of equal size (e.g., in a symmetric Doherty configuration), the main and peaking power transistor ICs may have unequal sizes, as well (e.g., in various asymmetric Doherty configurations). "size", as used herein, refers to the gate width of the transistor, or the current-carrying capacitor. In an asymmetric Doherty configuration, the peaking power transistor IC(s) typically are larger, that is to say they have a greater gate width, or a higher current-carrying capacity, than the main power transistor IC(s) by some multiplier. For example, the peaking power transistor IC(s) may be twice the size of the main power transistor IC(s) so that the peaking power transistor IC(s) have twice the current carrying capability of the main power transistor IC(s). Peaking-to-first amplifier IC size ratios other than a 2:1 ratio may be implemented, as well.

During operation of Doherty amplifier 100, first amplifier stage 136 is biased to operate in class AB mode, and second amplifier stage 146 is biased to operate in class C mode. More specifically, the transistor arrangement of first amplifier stage 136 is biased to provide a conduction angle between 180 and 360 degrees. Conversely, the transistor arrangement of the second amplifier stage 146 is biased to provide a conduction angle less than 180 degrees.

At low power levels at which the power of the input signal at terminal 102 is lower than the turn-on threshold level of second amplifier 146, the amplifier 100 operates in a low-power (or back-off) mode in which the first amplifier 136 is the only amplifier supplying current to the load 106. When the power of the input signal exceeds a threshold level of the second amplifier 146, the amplifier 100 operates in a high-power mode in which the first amplifier 136 and the second amplifier 146 both supply current to the load 106. At this point, the second amplifier 146 provides active load modulation at combining terminal 160, allowing the current of the first amplifier 136 to continue to increase linearly.

An input impedance matching network 134 (input MNc) may be implemented at the input of the first amplifier 136. Similarly, an input impedance matching network 144 (input MNp) may be implemented at the input of the second amplifier 146. In each case, the matching networks 134, 144 may be used to incrementally increase the circuit impedance toward the load impedance. In addition, the first amplifier 136 and the second amplifier 146 may have additional pre-matching input and/or output impedance matching networks (not illustrated) that are either integrated with the power transistor dies, or integrated within the power transistor die packages.

Conventional Doherty amplifier 100 has a "non-inverted" load network configuration. In the non-inverted configuration, the input circuit is configured so that an input signal supplied to the second amplifier 146 is delayed by 90 degrees with respect to the input signal supplied to the first amplifier 136 at the center frequency of operation, fo, of the amplifier 100. To ensure that the main and peaking input RF signals arrive at the main and second amplifiers 136, 146 with about 90 degrees of phase difference, as is fundamental to proper Doherty amplifier operation, a phase delay element 132 is provided, in the input path to the second amplifier 146, which applies about 90 degrees of phase delay to the peaking input signal. For example, phase delay element 132 may be a quarter wave transmission line, or another suitable type of delay element with an electrical length of about 90 degrees.

To compensate for the resulting 90 degree phase delay difference between the main and second amplifier paths 130, 140 at the inputs of amplifiers 136, 146 (i.e., to ensure that the amplified signals arrive in phase at the combining terminal 160), the output circuit is configured to apply about a 90 degree phase delay to the signal between the output of first amplifier 136 and the combining terminal 160. This is achieved through an additional delay element 150. Alternate embodiments of Doherty amplifiers may have an "inverted" load network configuration. In such a configuration, the input circuit is configured so that an input signal supplied to the first amplifier 136 is delayed by 90 degrees with respect to the input signal supplied to the second amplifier 146 at the center frequency of operation, fo, of the amplifier 100, and the output circuit is configured to apply about a 90 degree phase delay to the signal between the output of second amplifier 146 and the combining terminal 160.

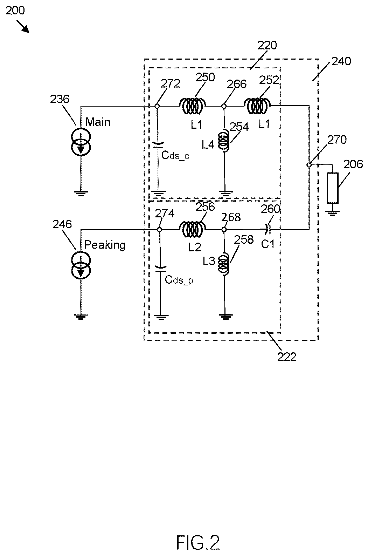

FIG. 2 is a simplified schematic diagram of a circuit arrangement for a Doherty amplifier having a main amplifier and a peaking amplifier in accordance with an embodiment. The circuit arrangement 200 comprises an output combiner circuit 240 including a first output network 220 having a first amplifier output node 272 for connection to a first output of the main amplifier 236, a second output network 222 having a second amplifier output node 274 for connection to a second output of the peaking amplifier 246, and a final summing node 270.

The first output network 220 comprises a first inductive element 250 connected between the first amplifier output node 272 and a first intermediate node 266, a second inductive element 252 connected between the first intermediate node 266 and the final summing node 270, and a third inductive element 254 connected between the first intermediate node 266 and ground. The second output network 222 comprises a fourth inductive element 256 connected between the second amplifier output node 274 and a second intermediate node 268, a fifth inductive element 258 connected between the second intermediate node 268 and ground, and a first capacitive element 260 connected between the second intermediate node 268 and the final summing node 270. Compared to traditional circuit arrangements for a conventional Doherty amplifier which has fixed load impedance or only can modify the real part of the load impedance, the proposed circuit arrangement can provide an output Doherty combiner for an advanced complex combining load (ACCL) Doherty amplifier which increases design freedom because the real part and the image part of the complex load impedance can be adjusted separately to meet different requirements.

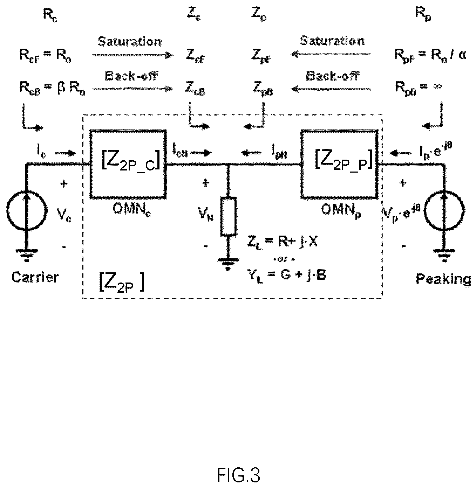

The theory and design methodology for the circuit arrangement 200 will be described together with FIG. 2 and FIG. 3 as below.

FIG. 3 is a Doherty amplifier model with a complex combing load. A 2-port combiner network $Z_{2P}$ can be constructed by the complex load $Z_L$, the carrier and peaking lossless output matching networks. As shown in FIG. 3, the $Z_{2P}$ network is the cascade of the $Z_L$ load, the carrier network $Z_{2P\_C}$ and the peaking network $Z_{2P\_P}$. For the sake of convenience, the transmission matrix format (ABCD-matrix) will be used for characterizing the $Z_{2P\_C}$ and $Z_{2P\_P}$.

$$Z_{2P} = \begin{bmatrix} \beta R_o & \frac{1-\beta}{\alpha} R_o e^{j\theta} \\ \frac{1-\beta}{\alpha} R_o e^{j\theta} & \frac{R_o}{\alpha} + \frac{\beta-1}{\alpha^2} R_o e^{j2\theta} \end{bmatrix} \tag{A1}$$

$$T_{2P} = T_{2P_{-c}} \cdot T_{Z_L} \cdot T_{2P_{-p}} = \begin{bmatrix} A_c & jB_c \\ jC_c & D_c \end{bmatrix} \begin{bmatrix} 1 & 0 \\ G+jB & 1 \end{bmatrix} \begin{bmatrix} A_p & jB_p \\ jC_p & D_p \end{bmatrix} \tag{A2}$$

where the $T_{2P\_c}$ and $T_{2P\_p}$ matrixes are the transmission matrix format of the $Z_{2P\_c}$ and $Z_{2P\_p}$ matrixes, and $T_{ZL}$ is the transmission matrix format of the complex load $Z_L$. $\alpha$ is denoted as the ratio of peaking amplifier size (or gate width of the transistor of the peaking amplifier) to main amplifier size(or gate width of the transistor of the main amplifier), and $\beta$ is the load modulation ratio, denoting the ratio of the load impedance seen by the intrinsic current generator of the carrier amplifier at the design output back-off condition to the load impedance seen at the maximum power operating. $\theta$ is the phase offset between the main and peaking paths. $R_o$ presents the optimum load impedance of the main amplifier at the full power. The combining node impedance is a complex value $Z_L$; the combining node impedance can be alternatively expressed in an admittance form: $Y_L = G+j*B$, where $1/Z_L = G+j*B$.

Assuming the output matching networks of the main and peaking are reciprocal and lossless, the diagonal elements of the ABCD-matrixes ($T_{2P\_c}$ and $T_{2P\_p}$) are purely real values, while the off-diagonal elements of the ABCD-matrixes are purely imaginary values.

$$T_{2P_c} = \begin{bmatrix} A_c & jB_c \\ jC_c & D_c \end{bmatrix} \qquad (A3)$$

$$T_{2P\_p} = \begin{bmatrix} A_p & jB_p \\ jC_p & D_p \end{bmatrix} \qquad (A4)$$

where Ac, Bc, Cc, Dc, Ap, Bp, Cp and Dp are real values.

Based on (A1) and (A2), The parameters of the main and peaking output matching networks could be calculated by the below equations:

$$D_c = \pm\sqrt{\frac{(\beta - \alpha - 1)}{(\beta^2 - 1)R_o G}} \qquad (A5)$$

$$B_c = \mp sign(\cos\theta)\sin\theta\sqrt{\frac{\beta R_o}{G}} \qquad (A6)$$

$$C_c = \mp\left(sign(\cos\theta)\frac{1}{\sin\theta}\sqrt{\frac{G}{\beta R_o}}\right) + A_c\frac{\cos\theta}{R_o\beta\sin\theta} \qquad (A7)$$

$$A_p = \mp sign(\cos\theta)\sqrt{\frac{\beta}{R_o G}}\cdot\frac{\alpha}{\beta - 1} \qquad (A8)$$

$$B_p = \mp\frac{\sin\theta}{\alpha}\sqrt{\frac{(\beta - \alpha - 1)(\beta + 1)R_o}{G(\beta - 1)}} \qquad (A9)$$

$$C_p = \mp sign(\cos\theta)\sqrt{\frac{\beta G}{R_0}}\cdot\frac{\alpha}{\beta - 1}\left(\frac{\cos\theta}{\sin\theta} - \frac{B}{G}\right) + A_c\frac{\alpha}{\sin\theta R_o(\beta - 1)} \qquad (A10)$$

$$D_p = \mp\left[sign(\cos\theta)\sqrt{\beta G R_o}\cdot\frac{(\alpha\beta - \beta + 1)}{\alpha\beta(\beta - 1)} + \frac{\sin\theta}{\alpha}\sqrt{\frac{(\beta - \alpha - 1)(\beta + 1)R_o}{G(\beta - 1)}}B\right]$$
$$- sign(\cos\theta)\frac{A_c}{\alpha}\sqrt{\frac{(\beta - \alpha - 1)(\beta + 1)}{\beta(\beta - 1)}} \qquad (A11)$$

where Ac is a free design variable, $R_o$ is the optimum load resistance of the main amplifier, G is the real part and B is the image part of the admittance of the combining node respectively (free design variables), and the function sign(x) is a sign function defined in the following:

$$\text{sign}(x) = \begin{cases} 1 & x \geq 0 \\ -1 & x < 0 \end{cases} \qquad (A12)$$

Since Dc has two solutions (use either the positive or negative sign), there are two sets of the solution: (1) when Dc uses the positive sign, the positive/negative sign ($\pm$) in other parameters expressions (Bc, Cc, Ap, Bp, Cp and Dp) will adopt the negative sign; (2) when Dc uses the negative sign, the positive/negative sign ($\pm$) in other parameters expressions will adopt the positive sign.

The optimum load impedance of the peaking amplifier is R0/$\alpha$, and the design output back-off (OBO) in dB is:

$$OBO = 10\log\big(\beta(1 + \alpha)\big) \qquad (A13)$$

The expression for $\theta$ could be calculated as below:

$$\theta = \pm\cos^{-1}\sqrt{\frac{\beta^2 - \alpha\beta - \beta}{\beta^2 - 1}} \ , or \ \pm\left(\pi - \cos^{-1}\sqrt{\frac{\beta^2 - \alpha\beta - \beta}{\beta^2 - 1}}\right) \qquad (A14)$$

The impedances at the combining node at both back-off and full power output conditions can be obtained:

$$Z_{cF} = \frac{R_o D_c - jB_c}{A_c - jC_c R_o} \qquad (A15)$$

$$Z_{cB} = \frac{\beta R_o D_c - jB_c}{A_c - jC_c \beta R_o} \qquad (A16)$$

$$Z_{pF} = conj\left(\frac{A_p R_o + j\alpha B_p}{\alpha D_p + jC_p R_o}\right) \qquad (A17)$$

$$Z_{pB} = j\frac{A_p}{C_p} \qquad (A18)$$

where the subscripts of each impedance refer to the different meanings and different conditions: the "c" stands for the main (that is to say, the first) amplifier while the "p" stands for the peaking (that is to say, the second) amplifier, and the "F" stands for the full power output condition while the "B" stands for the output back-off condition. For example, $Z_{pB}$ denotes the impedance of the peaking amplifier at the output back-off condition and $Z_{pF}$ denotes the impedance of the peaking amplifier at the full output condition. $Z_{cB}$ denotes the impedance of the main amplifier at the output back-off condition and $Z_{cF}$ denotes the impedance of the main amplifier at the full power output condition.

The traditional complex combining load (CCL) Doherty amplifier has such assumptions: $Z_{pB} = \infty$, and both of the two impedances ($Z_{cF}$ and $Z_{pF}$) relate to $Z_L$ and have the same phase (e.g. $Z_{cF} = Z_{pF} = 2Z_L$, for the symmetric case) to meet the Doherty amplifier operation.

In contrast, in the proposed advanced complex combining load (ACCL) Doherty amplifier, there is no assumption on the impedance $Z_{cF}$, $Z_{pF}$, $Z_{pB}$ and $Z_{cB}$, which in consequence could be any values that meet the required Doherty operation.

Also, the transmission matrixes of output matching network of both the main and the peaking of the ACCL Doherty amplifier are not fully determined when R (or G in Fig.3), $\alpha$ and $\beta$ are selected, because it still has two free design variables. One of the two free design variables can be any one of the eight parameters: Ac, Bc, Cc, Dc, Ap, Bp, Cp and Dp. The other is the image part X (or B in Fig.3) of the combining load impedance $Z_L$. The two-above design free variables are independent of each other. Then, the two free design variables can be adjusted to get the required complex combining load impedance $Z_L$.

Referring back to FIG. 2, there are six elements to form the output combiner circuit by using the advanced complex combining load (ACCL) technology. As shown in FIG. 2, the first inductive element 250 and the second inductive element 252 may have the same inductance value $L_1$. The inductance value of the fourth inductive element 256 is $L_2$. The inductance value of the fifth inductive element 258 is $L_3$. The inductance value of the third inductive element 254 is $L_4$. The capacitance of the first capacitor 260 is $C_1$. The parasitic capacitances of the main and peaking die blocks ($C_{ds\_c}$ and $C_{ds\_p}$) can be absorbed as parts of the output combiner circuit. In one embodiment, the first inductive element 250 and the second inductive element 252 have the same inductance value $L_1$ for simplicity. In some other embodiments, the first inductive element 250 and the second inductive element 252 may have different inductance values.

According to FIG. 2 and FIG. 3, to form an ACCL Doherty combiner, these above elements' values and the combining node impedance must obey some relationship (A1-A16). Given that Cds_c and Cds_p values of the main and peaking transistors are known, the values of $L_1$, $L_2$, $L_3$, $L_4$ and the complex impedance $Z_L$ (or in an admittance form $Y_L = G + j*B$) at the combining node could be obtained by the below equations:

$$L_1 = \frac{B_c}{\omega D_c + B_c \omega^2 C_{ds\_c} + \omega} \tag{1}$$

$$L_2 = \frac{1 + B_p \omega C_1}{\left(\omega C_{ds\_p} \cdot B_p + A_p\right)\omega^2 C_1} \tag{2}$$

$$L_3 = \frac{1}{\left(1 - \omega C_{ds\_p} \cdot B_p - A_p\right)\omega^2 C_1} \tag{3}$$

$$L_4 = \frac{B_c}{\left(1 - D_c - B_c \omega C_{ds\_c}\right)\left(1 + D_c + B_c \omega C_{ds\_c}\right)\omega} \tag{4}$$

$$B = -\frac{B_p^2 \omega^2 C_1 C_{ds\_p} + \left(A_p - 1\right)B_p \omega C_1 - 1}{B_p\left(B_p \omega C_{ds\_p} + A_p\right)} - \frac{\alpha\beta - \beta + 1}{(\beta - 1)^2 A_p B_p} + \frac{D_c}{B_c} + \omega C_{ds_c} \tag{5}$$

$$G_L = G \tag{6}$$

where the Bc, Dc, Ap, Bp could be obtained by the equations (A5, A6, A8 and A9), and G is a free design variable in the equations (A5, A6, A8 and A9). $C_1$ is a free design variable which can be selected freely. Having two free design variables (G and $C_1$) means the combing node impedance ($Z_L$) can be adjusted freely including its real and image parts. It provides flexibility to design circuit according to real applications or trade-off with other design aspects.

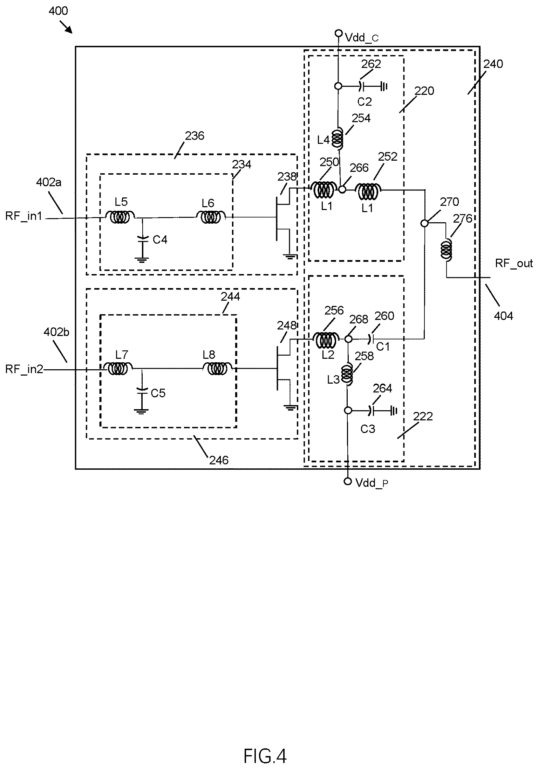

FIG. 4 is a circuit arrangement for a Doherty amplifier in accordance with an embodiment. The circuit arrangement 400 comprises two separate inputs 402a, 402b, an output 404, a first amplifier 236, a second amplifier 246, and an output combiner circuit 240. The main difference between the circuit arrangement 400 and the circuit arrangement 200 of FIG. 2 is that the circuit arrangement 400 comprises drain voltage bias circuits.

A first signal (RF_in1) received at the first input 402a is amplified by the first amplifier 236. A second signal (RF_in2) received at the second input 402b is amplified by the second amplifier 246.

The first amplifier (main amplifier) 236 includes a first transistor (carrier transistor) 238 which may comprise a control terminal connected to the input 402a, a source terminal connected to ground, and a drain terminal as a first amplifier output.

The second amplifier (peaking amplifier) 246 includes a second transistor (peaking transistor) 248 which may comprise a control terminal connected to the second input 402b, a source terminal connected to ground, and a drain terminal as a second amplifier output.

The output combiner circuit 240 includes a first output network 220, a second output network 222 and a final summing node 270. The first output network 220 is connected to the first amplifier output and the second output network 222 is connected to the second amplifier output. The first output network 220 may comprise a first inductive element 250 connected between the first amplifier output and a first intermediate node 266, a second inductive element 252 connected between the first intermediate node 266 and the final summing node 270. In one or more embodiments, the first inductive element and the second inductive element may have the same inductance value. The first output network 220 further comprises a third inductive element 254 connected between the intermediate node 266 and ground. The second output network 222 comprises a fourth inductive element 256 connected between the second amplifier output and a second intermediate node 268 and a first capacitor 260 connected between the second intermediate node 268 and the final summing node 270. The second output network 222 further comprises a fifth inductive element 258 connected between the second intermediate node 268 and ground.

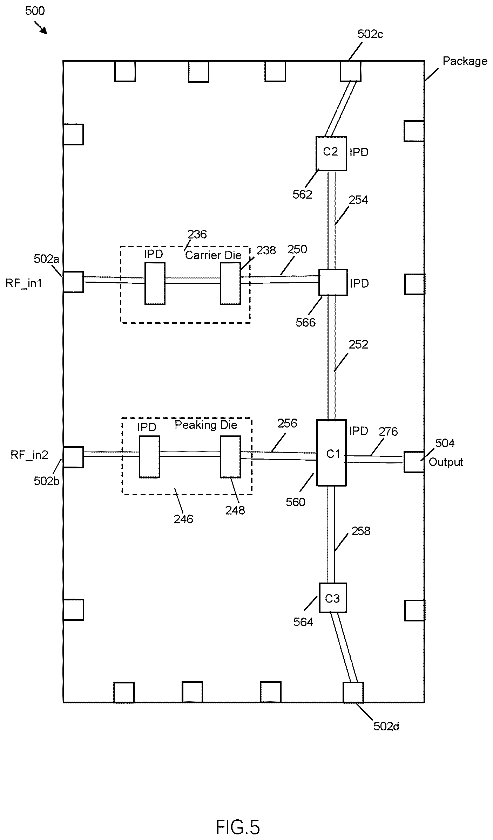

In one or more embodiments, the output combiner circuit 240 comprises a second capacitor 262 connected between the third inductive element 254 and ground, and a third capacitor 264 connected between the fifth inductive element 258 and ground. Then the third inductive element 254 and the fifth inductive element 258 can be referred as connected to RF ground, which means RF signals from the first transistor 238 are connected to ground and the DC current from the first VDD supply (Vdd_c) can be provided to the drain of the first transistor 238, and the RF signals from the second transistor 248 are connected to ground and the DC current from the second VDD supply (Vdd_p) can be provided to the drain of the second transistor 248. Each of the first inductive element, the second inductive element, the third inductive element, the fourth inductive element, and the fifth inductive element comprises a respective set of bond wires. The Doherty amplifier 200 comprises integrated passive devices (IPD) (shown in FIG. 5). The first capacitor 260 is integrated within a first integrated passive device (IPD), the second capacitor 262 is integrated within a second IPD, and the third capacitor 264 is integrated within a third IPD (shown in FIG. 5).

In one or more embodiments, the main amplifier 236 comprises a first amplifier input connected to the first input 402a, and a first amplifier output connected to the first output network 220; the peaking amplifier 246 comprises a second amplifier input connected to the second input 402b, and a second amplifier output connected to the second output network 222.

In one or more embodiments, the main amplifier 236 comprises a first input impedance matching network 234 and a first power transistor 238. The first input impedance matching network 234 is configured to match the impedance between the first input 402a and the first power transistor 238; and the peaking amplifier 246 comprises a second input impedance matching network 244 and a second power transistor 248. The second input impedance matching network 244 is configured to match the impedance between the second input 402b and the second power transistor 248.

In one or more embodiments, the first power transistor 238 is a field effect transistor with a gate terminal connected to the first input impedance matching network 234, a drain terminal connected to the first output network 220, and a source terminal connected to ground, and the second power transistor 248 is a field effect transistor with a gate terminal connected to the second input impedance matching network 244, a drain terminal connected to the second output network 222, and a source terminal connected to ground.

FIG. 5 is a physical layout of a packaged amplifier device in accordance with an embodiment. The packaged amplifier device 500 is at least a part of a Doherty amplifier.

The device may include a "flat no-leads" device package (e.g., a quad-flat no-leads QFN) or dual-flat no-leads (DFN) device). Such a device includes a "lead frame" consisting of a conductive central flange ("exposed thermal paddle") and a plurality of perimeter IO pads or leads (referred to as "pin pads" in the application). The flange and the pads are held in fixed orientation with respect to each other (and electrically isolated from each other) with plastic.

The various amplifier dies and the "integrated passive devices" (IPDs) referred to in the application may be all directly attached to the conductive flange, and bond wires may be connected between the top internal surfaces of the pin pads and the dies/IPDs. Plastic molding compound may be then applied over the dies to encapsulate the device. When connected to a PCB, the flange is typically grounded; this provides a ground reference for the encapsulated dies/IPDs. Such a device is typically a surface mount device, so the bottom surfaces of the pin pads are connected (e.g., soldered) to corresponding pads on the top surface of the PCB.

An IPD, as discussed herein, is a, typically small, semiconductor die that includes only "passive" components (e.g., capacitors, resistors, inductive elements) integrated therein, as opposed to an "active" device that is a semiconductor die that includes a transistor. In this application, each IPD may include a bond pad on its top surface to which a bond wire may be connected. The IPD includes an integrated, internal capacitor (usually a "metal insulator metal" or MIM capacitor). One terminal of the capacitor is connected to the top bond pad. The other terminal of the capacitor is connected to a conductive layer on the bottom of the IPD. When the IPD is connected (e.g., using solder) to the top surface of the conductive package flange, the second terminal of the capacitor may be grounded.

Referring again to FIG. 5, the packaged amplifier device 500 comprises a first input lead 502a and a second input lead 502b, an output lead 504, a first amplifier 236, a second amplifier 246, a first inductive element 250, a second inductive element 252, a third inductive element 254, a fourth inductive element 256, a fifth inductive element 258, and a first capacitor C1, a second capacitor C2 and a third capacitor C3. Each of the first inductive element, the second inductive element, the third inductive element, the fourth inductive element, and the fifth inductive element comprises a respective set of bond wires. The first capacitor C1 is integrated within a first integrated passive device (IPD) 560, the second capacitor C2 is integrated within a second IPD 562, and the third capacitor C3 is integrated within a third IPD 564. The various leads 502a, 502b, 502c, 502d, 504 each could be a terminal (or pin) of a no-leads package, for example.

The first amplifier 236 (e.g., a main amplifier of a Doherty amplifier) may include a first transistor 238. The first transistor 238 comprises a first transistor input connected to a first input lead 502a (e.g., through two sets of bond wires and a first input IPD, as shown), and a first transistor output. The second amplifier 246 (e.g., a first peaking amplifier of a Doherty amplifier) comprises a second transistor 248. The second transistor 248 includes a second transistor input connected to the second input lead 502b (e.g., through two sets of bond wires and a second input IPD, as shown), and a second transistor output.

The first inductive element 250 is connected between the first transistor output and an IPD 566, the second inductive element 252 is connected between the IPD 566 and the first capacitor 260, the third inductive element 254 is connected between the IPD 366 and ground. Then the first inductive element 250, the second inductive element 252 and the third inductive element 254 are connected to each other through the IPD 366.

The fourth inductive element 256 is connected between the second transistor output and the first terminal of the first capacitor C1. The second terminal of the first capacitor C1 is connected to the second inductive element 252. Both the first terminal and the second terminal of the first capacitor C1 are integrated in one IPD 560. The first capacitor C1 may be connected to the output lead 504 through another inductive element 276. The fifth inductive element 258 is connected between the first terminal of the first capacitor C1 and ground.

In one or more embodiments, the amplifier device 500 may comprise a second capacitor C2 on an IPD 562 and a third capacitor C3 on another IPD 564. The first terminal of the second capacitor C2 is connected to one terminal of the third inductive element 254 and a pin 502c which may be connected to a power supply Vdd_c. The first terminal of the third capacitor C3 is connected to one terminal of the fifth inductive element 258 and another pin 302d which may be connected to another power supply Vdd_p. Thus, there is no need to add any external circuit for drain biasing because the packaged amplifier device 500 itself provides drain voltage bias circuits which enables the drain voltage feeding for the first amplifier 236 and the second amplifier 246.

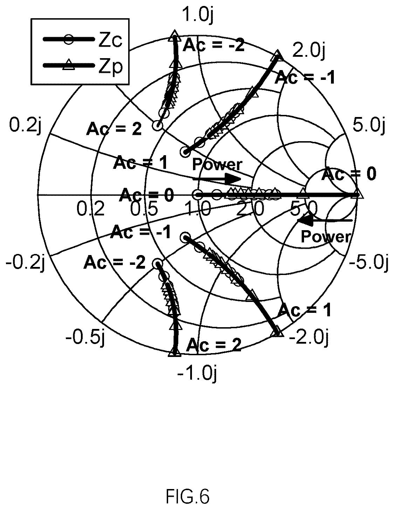

FIG. 6 is a Smith chart illustrating the impedance trajectories of Zc and Zp in accordance with one embodiment. In a conventional Doherty power amplifier (DPA) methodology, $\beta$ and $\theta$ are determined when the power ratio $\alpha$ is fixed. They are $\beta=\alpha+1$ and $\theta=\pm90°$. However, according to one or more embodiments, since the existence of the free variable Ac enables many alternatives, many complex impedances Zc and Zp can be achieved. As shown in FIG. 6, Ac=0 belongs to the conventional DPA, in which both Zc and Zp move along the real axis. Our proposal can give other possible solutions when Ac is selected as one of -2, -1, 1, 2.

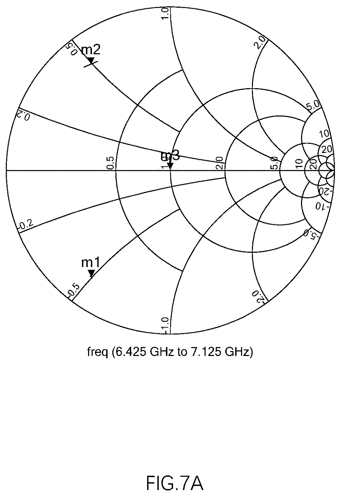

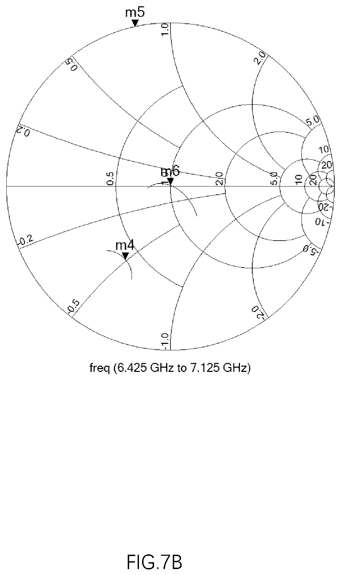

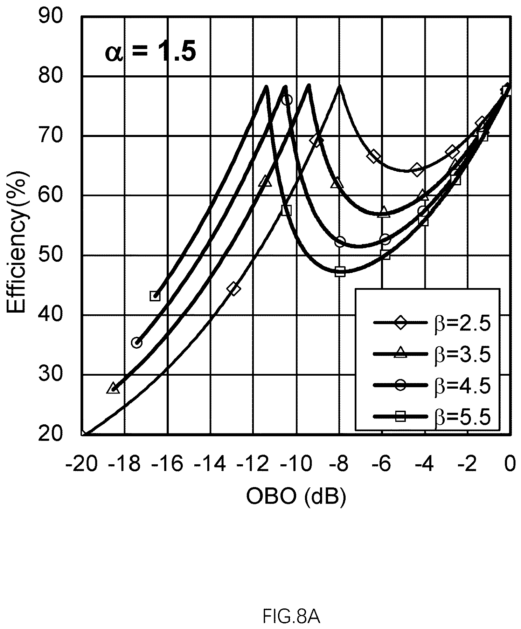

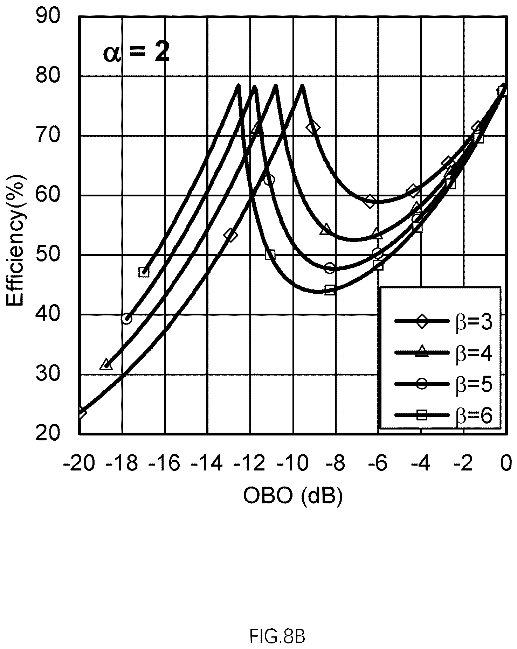

FIG. 7A and FIG. 7B is a Smith chart illustrating the impedance of Zc, Zp and ZL at the full power condition and the back off power condition with predetermined $\alpha$ = 1, $\beta$ = 3, $\theta$ = 127.76° and ZL = 50. Referring to FIG. 8A, based on the simulated load pull data at the full power condition, the ZcF of the main PA (m1) is 6.613-j24.811, the ZpF of the peaking pA (m2) is 6.541+j24.734 and the ZLoad_F of the output combiner circuit is 49.938+j0.391. Referring to FIG. 8B, based on the simulated load pull data at the back off power condition, the ZcB of the main PA (m4) is 19.834-j24.463, the ZpB of the peaking pA (m5) is 0.361+j40.171 and the ZLoad_B of the output combiner circuit (m6) is 49.448+j0.554. As shown in FIG. 7A and FIG. 7B, at either the full power output condition or the back-off condition, the impedances combined by the main and peaking networks can be the same as or very close to the complex load ZL we designed (ZL = 50). Although FIG. 7A and FIG. 7B show the ZL = 50, it should be understood that the load impedance may have any complex values as required.

FIG. 8A and FIG. 8B show the drain efficiency curves versus Output Back-Off (OBO) with different $\alpha$ and $\beta$ values. For a DPA circuit designer, more degrees of freedom are available in selecting the proper ratio $\alpha$ and modulation range $\beta$ to achieve the efficiency peak at the required OBO, based on the availability of the main and peaking amplifiers as well as their real performance characteristics.

Output Back Off (OBO) is the power level at the output of RF amplifier relative to maximum output level possible using the RF amplifier. The deep output back off means that the value of the output back off is larger than the normal back off value. For example, the value of the normal output back off is -8dB and the value of the deep output back off is -12dB.

In one or more embodiments, the value of $\beta$ can be chosen as any number equal to or greater than $\alpha+1$.

As shown in FIG. 8A, an expected drain efficiency can be realized by adjusting the value of $\beta$ when $\alpha$ equals to 1.5. For example, if the expected drain efficiency is 50% when the OBO is -12dB, $\beta$ may be one of the values 3.5, 4.5 and 5.5 while $\alpha$ equals to 1.5. If the expected drain efficiency is higher than 70% when the OBO is -12dB, $\beta$ may be chosen as 5.5 when $\alpha$ equals to 1.5.

As shown in FIG. 8B, an expected drain efficiency can be realized by adjusting the value of $\beta$ when $\alpha$ equals to 2. For example, if the expected drain efficiency is 50% when the OBO is -12dB, $\beta$ may be one of the values 3, 4, 5 and 6 while $\alpha$ equals to 2. If the expected drain efficiency is higher than 70% when the OBO is -12dB, $\beta$ may be chosen as 5 when $\alpha$ equals to 2.

Thus, the present application may enable advantages of high efficiency at deep output back-off (OBO), PCB size reduction, low cost, PCB design friendliness and application flexibility.

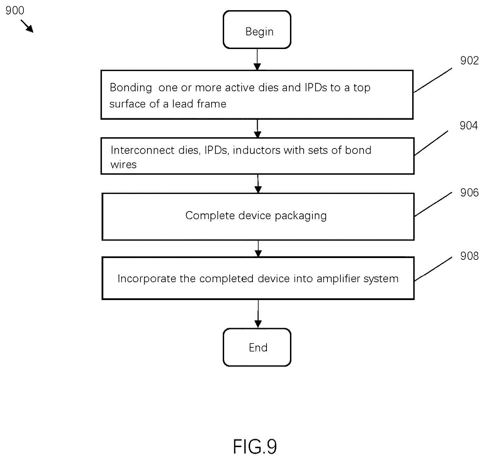

FIG. 9 is a flowchart of a method of fabricating a RF amplifier system in accordance with an example combination. In block 902, fabricating a packaged RF amplifier device may include bonding one or more active dies and other components (e.g. IPDs) to a top surface of a lead frame. In block 904, fabricating a packaged RF amplifier device may further include interconnect dies, IPDs, inductive elements in the form of sets of bond wires, between the input leads or pin pads, the active dies, the IPDs, the other components, and the output leads or pin pads. Connection of the bond wires essentially completes the formation of the amplifier paths, including the input and output impedance matching circuit. After attachment of the bond wires, packaging of the part of the RF amplifier may be completed in block 906. For example, in block 806, the active dies, IPDs, other components, bond wires, portions of the input and output leads, and at least part of the top surface of the lead frame are encapsulated with a nonconductive molding compound. Then in block 908, the completed device may be incorporated into an amplifier system which includes mounting the device on a PCB (or other substrate) so that the device substrate is electrically connected to the system's ground voltage reference.

Referring now to the use of the terms "a" and "an" and "the" and similar referents in the context of describing the subject matter (particularly in the context of the following claims) are to be construed to cover both the singular and the plural, unless otherwise indicated herein or clearly contradicted by context. Recitation of ranges of values herein are merely intended to serve as a shorthand method of referring individually to each separate value falling within the range, unless otherwise indicated herein, and each separate value is incorporated into the specification as if it were individually recited herein. Furthermore, the foregoing description is for the purpose of illustration only, and not for the purpose of limitation, as the scope of protection sought is defined by the claims as set forth hereinafter together with any equivalents thereof entitled to. The use of any and all examples, or exemplary language (e.g., "such as") provided herein, is intended merely to better illustrate the subject matter and does not pose a limitation on the scope of the subject matter unless otherwise claimed. The use of the term "based on" and other like phrases indicating a condition for bringing about a result, both in the claims and in the written description, is not intended to foreclose any other conditions that bring about that result. No language in the specification should be construed as indicating any non-claimed element as essential to the practice of the application as claimed.

Preferred embodiments are described herein, including the best mode known to the inventor for carrying out the claimed subject matter. Of course, variations of those preferred embodiments will become apparent to those of ordinary skill in the art upon reading the foregoing description. The inventor expects skilled artisans to employ such variations as appropriate, and the inventor intends for the claimed subject matter to be practiced otherwise than as specifically described herein. Accordingly, this claimed subject matter includes all modifications and equivalents of the subject matter recited in the claims appended hereto as permitted by applicable law. Moreover, any combination of the above-described elements in all possible variations thereof is encompassed unless otherwise indicated herein or otherwise clearly contradicted by context.

**Claims**

1.  A circuit arrangement for a Doherty amplifier having a main amplifier and a peaking amplifier, the circuit arrangement comprising:

    an output combiner circuit including a first output network having a first amplifier output node for connection to a first output of the main amplifier, a second output network having a second amplifier output node for connection to a second output of the peaking amplifier, and a final summing node;
    wherein the first output network comprises a first inductive element connected between the first amplifier output node and a first intermediate node, a second inductive element connected between the first intermediate node and the final summing node, and a third inductive element connected between the first intermediate node and ground; wherein the second output network comprises a fourth inductive element connected between the second amplifier output node and a second intermediate node, a fifth inductive element connected between the second intermediate node and ground, and a first capacitor connected between the second intermediate node and the final summing node.

2.  The circuit arrangement of claim 1, wherein the first output network comprises a second capacitor and the second output network comprises a third capacitor, and wherein a first terminal of the second capacitor is connected to the third inductive element and a first power supply; a second terminal of the second capacitor is connected to ground, and wherein a first terminal of the third capacitor is connected to the fifth inductive element and a second power supply, a second terminal of the third capacitor is connected to ground.

3.  The circuit arrangement of claim 2, wherein a voltage provided by the first power supply is the same as a voltage provided by the second power supply.

4.  The circuit arrangement of claim 2 or 3, wherein the first capacitor is integrated within a first integrated passive device,

IPD, the second capacitor is integrated within a second IPD, and the third capacitor is integrated within a third IPD.

5. The circuit arrangement of any preceding claim, wherein each one of the first inductive element, the second inductive element, the third inductive element, the fourth inductive element and the fifth inductive element comprises a respective set of bond wires.

6. The circuit arrangement of any preceding claim, wherein the amplifier comprises another inductive element connected between the final summing node and a Doherty amplifier output.

7. The circuit arrangement of any preceding claim, further comprising:
the main amplifier including a first amplifier input connected to a first input, and a first amplifier output connected to the first output network;
the peaking amplifier including a second amplifier input connected to a second input, and a second amplifier output connected to the second output network.

8. The circuit arrangement of claim 7, wherein the main amplifier comprises a first input impedance matching network and a first power transistor, wherein the first input impedance matching network is configured to match the impedance between the first input and the first power transistor; and the peaking amplifier comprises a second input impedance matching network and a second power transistor, wherein the second input impedance matching network is configured to match the impedance between the second input and second power transistor.

9. The circuit arrangement of claim 7, wherein: the first power transistor is a field effect transistor with a gate terminal connected to the first input impedance matching network, a drain terminal connected to the first inductive element, and a source terminal connected to ground, and the second power transistor is a field effect transistor with a gate terminal connected to the second input impedance matching network, a drain terminal connected to the fourth inductive element, and a source terminal connected to ground.

10. The circuit arrangement of any preceding claim, wherein the first inductive element and the second inductive element have the same inductance value.

11. The circuit arrangement of any preceding claim, wherein a ratio $\alpha$ of peaking amplifier size to main amplifier size is in the range of 1 to 3.

FIG.1

FIG.2

FIG.3

FIG.4

FIG.5

FIG.6

freq (6.425 GHz to 7.125 GHz)

FIG.7A

freq (6.425 GHz to 7.125 GHz)

FIG.7B

FIG.8A

FIG.8B

900

Begin

902

Bonding one or more active dies and IPDs to a top surface of a lead frame

904

Interconnect dies, IPDs, inductors with sets of bond wires

906

Complete device packaging

908

Incorporate the completed device into amplifier system

End

FIG.9

**EUROPEAN SEARCH REPORT**

Application Number

EP 25 20 4428

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 107 733 381 B (CHENGDU GANIDE TECH CO LTD) 27 October 2023 (2023-10-27) * paragraphs [0016] - [0053]; figure 2 * | 1-11 | INV. H03F1/02 H03F1/56 H03F3/195 |
| X | US 10 862 434 B1 (MCLAREN ROY [US]) 8 December 2020 (2020-12-08) * column 10, line 32 - column 24, line 67; figures 2,4 * | 1-11 | |
| A | RAMELLA CHIARA ET AL: "A Ka-band 33 dBm Stacked Power Amplifier Cell in 100 nm GaN-on-Si Technology", 2020 23RD INTERNATIONAL MICROWAVE AND RADAR CONFERENCE (MIKON), WARSAW UNIVERSITY OF TECHNOLOGY, 5 October 2020 (2020-10-05), pages 204-208, XP033858085, DOI: 10.23919/MIKON48703.2020.9253861 [retrieved on 2020-11-09] * abstract; figure 2 * | 1-11 | |
| A | CN 115 483 891 A (UNIV NANTONG) 16 December 2022 (2022-12-16) * paragraphs [0030] - [0039]; figures 1-3 * | 1-11 | TECHNICAL FIELDS SEARCHED (IPC) H03F |

The present search report has been drawn up for all claims

| Place of search | Date of completion of the search | Examiner |
|---|---|---|
| The Hague | 20 January 2026 | Zakharian, Andre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 4428

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2026

| Patent document cited in search report | | Publication date | Patent family member(s) | Publication date |
|---|---|---|---|---|
| CN 107733381 | B | 27-10-2023 | NONE | |
| US 10862434 | B1 | 08-12-2020 | NONE | |
| CN 115483891 | A | 16-12-2022 | NONE | |

EPO FORM P0459

For more details about this annex : see Official Journal of the European Patent Office, No. 12/82